# EUROPÄISCHE PATENTSCHRIFT

(11) **EP 1 121 790 B1**
(45) Veröffentlichungstag und Bekanntmachung des Hinweises auf die Patenterteilung: **27.09.2006**
(21) Anmeldenummer: 00945585.8
(22) Anmeldetag: 30.05.2000
(51) Int. Cl.: H04L 12/58

(54) **VERFAHREN UND TELEKOMMUNIKATIONSENDGERÄT ZUR AUTOMATISIERTEN DATENKOMPRIMIERUNG IN FUNKNETZ**
METHOD AND TELECOMMUNICATION TERMINAL FOR AUTOMATED DATA COMPRESSION IN RADIO COMMUNICATION SYSTEMS
PROCEDE ET TERMINAL DE TELECOMMUNICATION POUR LA COMPRESSION AUTOMATISEE DE DONNEES DANS DES SYSTEMES DE COMMUNICATION RADIO

(30) Priorität: 25.06.1999 DE 19929232
(43) Veröffentlichungstag der Anmeldung: 08.08.2001
(73) Patentinhaber: SIEMENS AKTIENGESELLSCHAFT, 80333 München (DE)
(72) Erfinder: NASSHAN, Markus, D-85435 Erding (DE)
(86) Internationale Anmeldenummer: PCT/DE2000/001752
(87) Internationale Veröffentlichungsnummer: WO 2001/001651

(56) Entgegenhaltungen:
- WO-A-97/38434
- WO-A-97/48212
- PATENT ABSTRACTS OF JAPAN vol. 1999, no. 01, 29. Januar 1999 (1999-01-29) & JP 10 285205 A (CASIO COMPUT CO LTD), 23. Oktober 1998 (1998-10-23)
- HOSHI T ET AL: "A MOBILE PEN-BASED COMPUTING SYSTEM FOR CELLULAR TELEPHONE NETWORKS" PROCEEDINGS OF THE GLOBAL TELECOMMUNICATIONS CONFERENCE (GLOBECOM),US,NEW YORK, IEEE, Bd. -, 29. November 1993 (1993-11-29), Seiten 380-384, XP000428085

## Beschreibung

Die Erfindung betriff ein Verfahren nach dem Oberbegriff des Anspruchs 1 sowie ein Telekommunikationsendgerät nach dem Oberbegriff von Anspruch 13.

Ein solches Verfahren bzw. ein solches Telekommunikationsendgerät sind aus der JP 10285205 A bekannt. Abhängig von einer bestimmten Dateigröße wird entschieden, ob eine Kompression der Datei vorzunehmen ist oder nicht. Das Verfahren wird dann von einem entsprechend modifiziertem Endgerät, ähnlichden aus WO 97/38434 A1 bekannten, ausgeführt.

Stand der Technik für die Erfindung ist außerdem der Offenbarungsgehalt der WO 97/38424 A1, in welcher ein Rekompressions-Server vorgestellt wird, der dazu in der Lage ist, vorkomprimierte Datenströme zu dekomprimieren und anschließend neu zu komprimieren, so dass sich insgesamt eine kleinere Dateigröße ergibt, als diejenige der vorkomprimierten Datei.

Angesichts der rasanten Entwicklung im Hardwarebereich der Computerindustrie, gewinnt der Multimedia-Markt zunehmend an Bedeutung. Es wird möglich, verschiedene Kommunikationsdienste wie Telefonie, Videotelefonie, Fax und Datentransfer über ein Endgerät und ein Telekommunikationsnetz abzuwickeln. Vor allem der Datenübertragung über ein Funkkommunikationssystem kommt eine immer größere Bedeutung zu. Möglich wurde diese Entwicklung unter anderem durch moderne, leistungsfähige, nach dem GSM-Standard konzipierte Mobilkommunikationsnetze.

Der Mobilnetz-Standard GSM steht für "Global System for Mobile Communication". Es ist der weitverbreitetste Mobilfunknetz-Standard der Welt, dem sich mittlerweile über 80 Staaten angeschlossen haben. In Deutschland erfüllen das D1 sowie das D2-Netz diesen Standard. Weitere Funk-Standards sind beispielsweise der CTS-Standard (CTS = GSM Cordless Telefony System), der DCS-Sandard (DCS = Digital Cellulare System Standard), oder der UMTS-Standard (UTMS = Universal Mobile Telecommunications System).

In Funkkommunikationssystemen werden häufig Daten in Form von Dateien von einem Server in einem Festnetz zu einem Telekommunikationsendgerät oder umgekehrt übertragen. Die zu übertragenden Dateien können entweder komprimiert oder nicht komprimiert (unkomprimiert) übertragen werden. Komprimierung bedeutet eine Verringerung der zu übertragenden Datenmengen. Ein häufig verwendetes Komprimierungsprogramm stellt das unter dem Betriebssystem WINDOWS zur Verfügung stehende Shareware-Programm "WinZip" dar.

Ein Beispiel zur Datenübertragung im Funkkommunikationsnetz ist der Remote-Email-Access im GSM-Netz. Dabei werden Daten in Form von Dateien an Emails angehängt und übertragen.

Dem Sender einer Email bleibt es überlassen, die Dateien, die an das Email angehängt werden, manuell zu komprimieren, oder nicht. In der Praxis kann festgestellt werden, daß ungefähr 90% der angehängten Dateien unkomprimiert übertragen werden. Dies zeigt, daß die manuelle Komprimierung von Dateien oftmals aus Bequemlichkeitsgründen, oder aus Vergeßlichkeit nicht durchgeführt wird. Häufig liegt auch Unkenntnis über die Technik des Komprimierens vor. Bei den übertragenen Daten handelt es sich häufig um Word oder Power Point-Dateien mit einer Größe von 200 kbyte und mehr.

Der Empfänger, beispielsweise eines Emails, hat derzeit keine Möglichkeit, unkomprimierte Dateien, die an dieses Email angehängt sind, vor der Übertragung vom Server auf sein Endgerät zu komprimieren. In der Regel kann der Empfänger nicht einmal erkennen, ob diese Datei komprimiert ist oder nicht. Bei unkomprimierten angehängten Dateien bedeutet dies eine circa zehnfach längere Übertragungszeit im Vergleich zu komprimierten Dateien.

Es ist daher Aufgabe der Erfindung, ein Verfahren zur Übertragung von Daten, insbesondere einer Datei die an eine sonstige Nachricht angehängt wird, in einem Kommunikationssystem, insbesondere einem Funkkommunikationssystem von einem Sender an einen Empfänger, sowie ein Telekommunikationsendgerät mit mindestens einem Sender und mindestens einem Empfänger zur Übertragung von Daten, insbesondere einer Datei, die an eine sonstige Nachricht angehängt wird, mit einem Prozessor und einem Speicher für Daten und Programme zu entwickeln, das eine Verkürzung der Übertragungszeiten dieser Datei bewirkt.

Die Aufgabe zur Entwicklung eines Verfahrens wird durch die Merkmale des Anspruches 1 gelöst, die Aufgabe zur Entwicklung eines Telekommunikationsendgerätes wird durch die Merkmale des Anspruches 13 gelöst.

Gemäß Anspruch 1 wird vorgeschlagen, ein Verfahren zur Übertragung von Daten, insbesondere einer Datei die an eine sonstige Nachricht angehängt wird, in einem Kommunikationssystem, insbesondere einem Funkkommunikationssystem von einem Sender an einen Empfänger zu entwickeln, das unkomprimierte Dateien vor der Übertragung auf vorhandene Komprimierung überprüft und die Dateigröße um mehr als 30%, vorzugsweise mehr als 50%, reduziert, wenn eine unkomprimierte Datei vorliegt.

Eine angehängte Datei wird dann als komprimierbar erkannt, wenn die Möglichkeit gegeben ist, die Dateigröße um mehr als 30% zu reduzieren beziehungsweise, wenn keine Komprimierungsmarkierung im Header der Datei oder keine spezifische Dateiendung (hier .zip) gefunden wird. Ein Header ist ein Datensatz mit einer bestimmten Anzahl an Zeichen, der Informationen über die angehängte Datei enthält, wie beispielsweise deren Größe, das Erstellungsdatum oder die Dateiform.

Falls eine unkomprimierte angehängte Datei vorliegt, wird eine Komprimierung durchgeführt. Dies geschieht mit Hilfe eines Komprimierungsprogrammes, das aufgerufen und aktiviert wird und zu einer Reduzierung der bestehenden Dateigröße führt. Hierbei wird eine spezifische Dateiendung angelegt, wie zum Beispiel ".zip".

Es ist denkbar, daß angehängte komprimierte Dateien zusätzlich, als Schutz vor unautorisierter Einsicht verschlüsselt werden. Hierzu stehen diverse Verschlüsselungsprogramme zur Verfügung, beispielsweise das Programm "Pretty Good Privacy" (PGP), das für Privatpersonen kostenlos aus dem Internet zugänglich ist.

Die verschlüsselten oder unverschlüsselten komprimierten Dateien, die an eine sonstige Nachricht angehängt werden, werden anstelle der nicht komprimierten Dateien von dem Sender zu dem Empfänger übertragen.

Hierbei kann das Telekommunikationsendgerät des Benutzers, je nach Richtung des Datenstroms, sowohl Sender als auch Empfänger sein. Ebenso kann der Server beide Funktionen ausüben.

Das Bindeglied zwischen dem Festnetz, dem der Server angehört, und dem Funkkommunikationssystem stellt eine Basisstation dar.

Gemäß Anspruch 14 wird vorgeschlagen, ein Telekommunikationsendgerät mit mindestens einem Sender und mindestens einem Empfänger zur Übertragung von Daten insbesondere einer Datei, die an eine sonstige Nachricht angehängt wird, mit einem Prozessor und einem Speicher für Daten und Programme dahingehend zu verbessern, daß ein Mittel zur Erkennung einer komprimierten Datei, beziehungsweise einer nicht komprimierten Datei und ein Mittel zur Komprimierung einer als nicht komprimiert erkannten angehängten Datei vorgesehen ist.

Dieses Mittel zur Komprimierung kann ein Komprimierungsprogramm oder ein Dekomprimierungsprogramm darstellen. Denkbar ist auch, daß das Mittel zur Erkennung einer vorliegenden Komprimierung einer Datei, die an eine sonstige Nachricht angehängt wird, ein Programm oder Programm-Modul ist.

Das Telekommunikationsendgerät kann in dem Funkkommunikationsnetz des GSM-Standards (GSM = Global System for Mobile Communication) beziehungsweise des CTS-Standards (CTS = GSM Cordless Telefony System), des DCS-Sandards (DCS = Digital Cellulare System Standard), oder des UMTS-Standards (UTMS = Universal Mobile Telecommunications System) Nachrichten, an die Dateien angehängt sind, übermitteln.

Die Übertragung von komprimierten angehängten Dateien im Vergleich zu unkomprimierten Dateien führt zu einer wesentlichen Verkürzung der Übertragungszeiten im Funkkommunikationssystem.

Als weiteren Vorteil der Erfindung ist anzuführen, daß dies zu einer deutlichen Kostensenkung pro Übertragung führt.

Die Erfindung läßt sich auf beliebige Kommunikationssysteme übertragen. Attraktiv ist die Anwendung besonders in Funkkommunikationssystemen, da in diesen Systemen die Übertragungskapazität des Funkkanals deutlich niedriger ist, als in drahtgebundenen oder optischen Kommunikationssystemen.

Nicht nur der Anwender hat von einer automatisierten Komprimierung von Dateien, die an eine sonstige Nachricht angehängt sind, Nutzen, auch für den Betreiber des Kommunikationssystems bringt dies Vorteile mit sich. Beispielsweise können so eine größere Anzahl an Teilnehmer in einem Funkkommunikationssystem gleichzeitig Dateien übertragen. Wartezeiten auf freie Leitungen werden reduziert.

Werden beim Empfänger eingehende angehängte Dateien als komprimiert erkannt, da beispielsweise ein entsprechender Verweis im Header steht beziehungsweise keine Komprimierung erfolgen kann, können diese dekomprimiert und für den Empfänger lesbar gemacht werden. Die Dekomprimierung der eingegangenen Daten muß nicht notwendigerweise automatisiert beim Eingang der Daten stattfinden, sondern kann bei Bedarf auch manuell erfolgen. Dies bietet den Vorteil, daß Speicherplatz für das lokale Postfach gespart wird.

Es versteht sich, daß die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

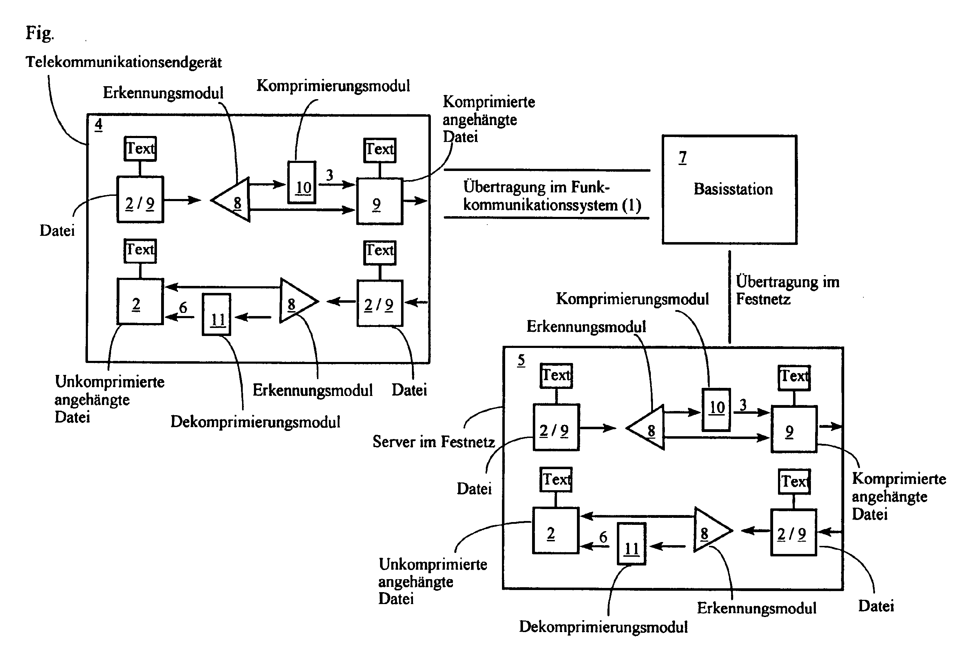

Weitere Merkmale der Erfindung ergeben sich aus den Unteransprüchen und der nachfolgenden Beschreibung eines Ausführungsbeispiels unter Bezugnahme auf die Zeichnung.

Im folgenden wird die Erfindung anhand der einzigen Zeichnung beschrieben:

Die Figur zeigt ein Schema eines erfindungsgemäßen Verfahrens zur Übertragung von Daten, insbesondere einer Datei die an eine sonstige Nachricht angehängt wird in einem Kommunikationssystem, insbesondere eines Funkkommunikationssystems 1, von einem Sender an einen Empfänger. Sender oder Empfänger können jeweils entweder der Server 5 oder das Telekommunikationsendgerät 4 sein.

Eine Datenübertragung zwischen einem Telekommunikationsendgerät 4 (zum Beispiel einem Handy) und einer Basisstation 7 findet im Funkkommunikationssystem 1 statt. Die Datenübertragung zwischen dem Server 5 und der Basisstation 7 findet im Festnetz statt.

Vor jeder Datenübertragung werden, sowohl beim Telekommunikationsendgerät 4 als auch beim Server 5, die zu übertragenden unkomprimierten Dateien 2 automatisch komprimiert 3. Diese Dateien sind an einen Text oder eine Nachricht angehängt. Dabei laufen im folgenden diese Schritte ab: Überprüfung, ob die angehängten Dateien komprimiert sind oder nicht. Hierfür ist ein Erkennungsmodul 8 vorhanden. Bei komprimierten Dateien 9 erfolgt direkt die Übertragung ins Datennetz. Falls die Dateien nicht komprimiert sind, wird eine Komprimierung 3 durchgeführt. Dies geschieht mit Hilfe eines Komprimierungsmoduls 10. Hierbei kann es sich um ein gängiges Komprimierungsprogramm ("WinZip") handeln. Anstelle der nicht komprimierten Dateien 2 werden die komprimierten Dateien 9, angehängt an eine sonstige Nachricht, übertragen.

Eine Dekomprimierung 6 der komprimierten Dateien 9 kann manuell oder automatisch erfolgen. Für den Fall, daß die Dekomprimierung 6 automatisch durchgeführt werden soll, überprüft ein Erkennungsmodul 8, zum Beispiel ein Programm-Modul, ob die empfangene Datei, die an eine sonstige Nachricht angehängt ist, komprimiert ist oder nicht, das heißt, ob beispielsweise die Dateiendung ".zip" vorhanden ist. Unkomprimierte Dateien 2 werden direkt übertragen, im Falle einer komprimierten Datei 9 wird ein Dekomprimierungsmodul 11, zum Beispiel ein Dekomprimierungsprogramm, aktiviert. Eine Dekomprimierung 6 muß nicht zwingend automatisch erfolgen, sondern kann bei Bedarf auch manuell erfolgen, um Speicherplatz einzusparen.

## Patentansprüche

1. Verfahren zur Übertragung von Daten, insbesondere einer Datei, die an eine Nachricht angehängt wird, in einem Kommunikationssystem, insbesondere einem Funkkommunikationssystem (1) von einem Sender an einen Empfänger, bei dem die Daten oder Datei vor der Übertragung auf vorhandene Komprimierung überprüft werden und unkomprimierte Daten, insbesondere unkomprimierte angehängte Datei (2), einem Komprimierungsverfahren (3) unterzogen werden, **dadurch gekennzeichnet, daß** die Datei nur dann komprimiert wird, wenn die große der Datei um mehr als 30% reduzierbar ist.

2. Verfahren zur Übertragung von Daten oder Datei, gemäß dem vorstehenden Anspruch 1, **dadurch gekennzeichnet, daß** eine Datei als unkomprimiert eingestuft wird, wenn eine auf bereits vorhandene Komprimierung hinweisende Dateiendung nicht vorhanden ist.

3. Verfahren zur Übertragung von Daten oder Datei gemäß einem der voranstehenden Ansprüche 1 bis 2, **dadurch gekennzeichnet, daß** eine Datei als unkomprimiert eingestuft wird, wenn eine auf bereits vorhandene Komprimierung hinweisende Markierung im Header der Datei nicht vorhanden ist.

4. Verfahren zur Übertragung von Daten oder Datei gemäß einem der voranstehenden Ansprüche 1 bis 3, **dadurch gekennzeichnet, daß** die zu komprimierenden Dateien durch Aufruf eines separaten Komprimierungsprogrammes komprimiert wird.

5. Verfahren zur Übertragung von Daten oder Datei gemäß einem der voranstehenden Ansprüche 1 bis 4, **dadurch gekennzeichnet, daß** zur Kennzeichnung der Komprimierung (3) eine Markierung im Header angelegt wird.

6. Verfahren zur Übertragung von Daten gemäß einem der voranstehenden Ansprüche 1 bis 5, **dadurch gekennzeichnet, daß** die Daten nach oder während der Komprimierung (3) verschlüsselt werden.

7. Verfahren zur Übertragung von Daten gemäß einem der voranstehenden Ansprüche 1 bis 6, **dadurch gekennzeichnet, daß** als Sender ein Telekommunikationsendgerät (4) verwendet wird.

8. Verfahren zur Übertragung von Daten gemäß einem der voranstehenden Ansprüche 1 bis 7, **dadurch gekennzeichnet, daß** als Sender ein Server (5) verwendet wird.

9. Verfahren zur Übertragung von Daten gemäß einem der voranstehenden Ansprüche 1 bis 8, **dadurch gekennzeichnet, daß** als Empfänger ein Telekommunikationsendgerät (4) verwendet wird.

10. Verfahren zur Übertragung von Daten gemäß einem der voranstehenden Ansprüche 1 bis 9, **dadurch gekennzeichnet, daß** als Empfänger ein Server (5) verwendet wird.

11. Verfahren zur Übertragung von Daten gemäß einem der voranstehenden Ansprüche 1 bis 10, **dadurch gekennzeichnet, daß** beim Empfänger eine Dekomprimierung (6) der empfangenen Datei stattfindet

12. Verfahren zur Übertragung von Daten gemäß einem der voranstehenden Ansprüche 1 bis 11, **dadurch gekennzeichnet, daß** eine Verbindung vom Sender zum Empfänger über eine Basisstation (7) erzeugt wird.

13. Telekommunikationsendgerät (4) mit mindestens einem Sender und mindestens einem Empfänger zur Übertragung von Daten, insbesondere einer Datei, die an eine Nachricht angehängt wird, mit einem Prozessor und einem Speicher für Daten und Programme, ein Mittel zur Erkennung (8) einer komprimierten Datei (9), beziehungsweise einer nicht komprimierten Datei (2) und ein Mittel zur Komprimierung (10) einer als nicht komprimiert erkannten angehängten Datei (2) **dadurch gekennzeichnet, dass** das Mittel zur Erkennung einer komprimierten Datei (9), bzw. einer nichtkomprimierten Datei (2) derart ausgebildet ist, dass eine Datei als unkomprimiert eingestuft wird, wenn es möglich ist, die Größe dieser Datei mehr als 30 % zu reduzieren.

14. Telekommunikationsendgerät gemäß dem voranstehenden Anspruch 13, **dadurch gekennzeichnet, daß** ein Mittel zur Dekomprimierung (11) der eingegangenen und als komprimiert erkannten angehängten Datei (9) vorgesehen ist.

15. Telekommunikationsendgerät gemäß einem der voranstehenden Ansprüche 13 bis 14, **dadurch gekennzeichnet, daß** das Mittel zur Komprimierung (10) oder das Mittel zur Dekomprimierung (11) ein Komprimierungs- oder Dekomprimierungsprogramm ist.

16. Telekommunikationsendgerät gemäß einem der voranstehenden Ansprüche 13 bis 15, **dadurch gekennzeichnet, daß** das Mittel zur Erkennung (8) einer Komprimierten Datei oder einer nicht Komprimierten Datei ein Programm oder Programm-Modul ist.

17. Telekommunikationsendgerät gemäß einem der voranstehenden Ansprüche 13 bis 16, **dadurch gekennzeichnet, daß** es sich bei dem von dem Telekommunikationsendgerät (4) verwendeten Funkkommunikationssystem (1) um einen GSM-Standard handelt.

18. Telekommunikationsendgerät gemäß einem der voranstehenden Ansprüche 13 bis 17, **dadurch gekennzeichnet, daß** es sich bei dem von dem Telekommunikationsendgerät (4) verwendeten Funkkommunikationssystem (1) um einen DCS-Standard handelt.

19. Telekommunikationsendgerät gemäß einem der voranstehenden Ansprüche 13 bis 18, **dadurch gekennzeichnet, daß** es sich bei dem von dem Telekommunikationsendgerät (4) verwendeten Funkkommunikationssystem (1) um einen UMTS-Standard handelt.

20. Telekommunikationsendgerät gemäß einem der voranstehenden Ansprüche 13 bis 19, **dadurch gekennzeichnet, daß** es sich bei dem von dem Telekommunikationsendgerät (4) verwendeten Funkkommunikationssystem (1) um einen CTS-Standard handelt.

## Claims

1. Method for transmitting data, in particular of a file, which is attached to a message, in a communication system, in particular in a radio communication system (1), from a transmitter to a receiver, in which the data or file are checked before transmission to verify if compression has taken place and non-compressed data, in particular non-compressed attached file (2), is/are subjected to a compression process (3), **characterized in that** the file is only compressed when the size of the file can be reduced by more than 30%.

2. Method for transmitting data or a file according to the preceding Claim 1, **characterized in that** a file is classified as non-compressed if a file ending indicating that compression has already taken place is not present.

3. Method for transmitting data or a file according to one of the preceding Claims 1 and 2, **characterized in that** a file is classified as non-compressed if a marking in the header of the file indicating that compression has already taken place is not present.

4. Method for transmitting data or a file according to one of the preceding Claims 1 to 3, **characterized in that** the files to be compressed are compressed by calling up a separate compression program.

5. Method for transmitting data or a file according to one of the preceding Claims 1 to 4, **characterized in that** a marking in the header is created for the identification of the compression (3).

6. Method for transmitting data according to one of the preceding Claims 1 to 5, **characterized in that** the data are coded after or during the compression (3).

7. Method for transmitting data according to one of the preceding Claims 1 to 6, **characterized in that** a telecommunication terminal (4) is used as the transmitter.

8. Method for transmitting data according to one of the preceding Claims 1 to 7, **characterized in that** a server (5) is used as the transmitter.

9. Method for transmitting data according to one of the preceding Claims 1 to 8, **characterized in that** a telecommunication terminal (4) is used as the receiver.

10. Method for transmitting data according to one of the preceding Claims 1 to 9, **characterized in that** a server (5) is used as the receiver.

11. Method for transmitting data according to one of the preceding Claims 1 to 10, **characterized in that** a decompression (6) of the file received takes place at the receiver.

12. Method for transmitting data according to one of the preceding Claims 1 to 11, **characterized in that** a connection from the transmitter to the receiver is created via a base station (7).

13. Telecommunication terminal (4) with at least one transmitter and at least one receiver for transmitting data, in particular of a file which is attached to a message, with a processor and a memory for data and programs, a means for identifying (8) a compressed file (9), or a non-compressed file (2), and a means for compressing (10) an attached file (2) identified as non-compressed, **characterized in that** the means for identifying a compressed file (9), or a non-compressed file (2) is designed such that a file is classified as non-compressed if it is possible to reduce the size of this file by more than 30%.

14. Telecommunication terminal according to the preceding Claim 13, **characterized in that** a means for decompressing (11) the attached file (9) which has come in and been identified as compressed is provided.

15. Telecommunication terminal according to either of the preceding Claims 13 and 14, **characterized in that** the means for compressing (10) or the means for decompressing (11) is a compression or decompression program.

16. Telecommunication terminal according to one of the preceding Claims 13 to 15, **characterized in that** the means for identifying (8) a compressed file or a non-compressed file is a program or program module.

17. Telecommunication terminal according to one of the preceding Claims 13 to 16, **characterized in that** the radio communication system (1) used by Telecommunication terminal (4) is a GSM standard.

18. Telecommunication terminal according to one of the preceding Claims 13 to 17, **characterized in that** the radio communication system (1) used by Telecommunication terminal (4) is a DCS standard.

19. Telecommunication terminal according to one of the preceding Claims 13 to 18, **characterized in that** the radio communication system (1) used by Telecommunication terminal (4) is a UMTS standard.

20. Telecommunication terminal according to one of the preceding Claims 13 to 19, **characterized in that** the radio communication system (1) used by Telecommunication terminal (4) is a CTS standard.

## Revendications

1. Procédé pour la transmission de données, notamment d'un fichier qui est joint à un message, d'un expéditeur à un destinataire dans un système de communication, notamment dans un système de radiocommunication (1), dans lequel les données ou le fichier sont vérifiés avant la transmission pour savoir s'ils sont compressés ou non et des données non compressées, notamment un fichier joint (2) non compressé, sont soumises à un procédé de compression (3),
**caractérisé par le fait que** le fichier n'est compressé que si la taille du fichier peut être réduite de plus de 30 %.

2. Procédé pour la transmission de données, ou fichier, selon la revendication précédente 1, **caractérisé par le fait qu'**un fichier est classé comme non compressé s'il n'y a pas d'extension de fichier signalant une compression déjà existante.

3. Procédé pour la transmission de données, ou fichier, selon l'une des revendications précédentes 1 à 2, **caractérisé par le fait qu'**un fichier est classé comme non compressé s'il n'y a pas de marque signalant une compression déjà existante dans l'en-tête du fichier.

4. Procédé pour la transmission de données, ou fichier, selon l'une des revendications précédentes 1 à 3, **caractérisé par le fait que** le fichier à compresser est compressé par l'appel d'un programme de compression séparé.

5. Procédé pour la transmission de données, ou fichier, selon l'une des revendications précédentes 1 à 4, **caractérisé par le fait qu'**une marque est placée dans l'en-tête pour caractériser la compression (3).

6. Procédé pour la transmission de données selon l'une des revendications précédentes 1 à 5, **caractérisé par le fait que** les données sont cryptées après ou pendant la compression (3) .

7. Procédé pour la transmission de données selon l'une des revendications précédentes 1 à 6, **caractérisé par le fait qu'**un terminal de télécommunication (4) est utilisé comme expéditeur.

8. Procédé pour la transmission de données selon l'une des revendications précédentes 1 à 7, **caractérisé par le fait qu'**un serveur (5) est utilisé comme expéditeur.

9. Procédé pour la transmission de données selon l'une des revendications précédentes 1 à 8, **caractérisé par le fait qu'**un terminal de télécommunication (4) est utilisé comme destinataire.

10. Procédé pour la transmission de données selon l'une des revendications précédentes 1 à 9, **caractérisé par le fait qu'**un serveur (5) est utilisé comme destinataire.

11. Procédé pour la transmission de données selon l'une des revendications précédentes 1 à 10, **caractérisé par le fait qu'**une décompression (6) du fichier reçu a lieu chez le destinataire.

12. Procédé pour la transmission de données selon l'une des revendications précédentes 1 à 11, **caractérisé par le fait qu'**une liaison de l'expéditeur au destinataire est produite via une station de base (7).

13. Terminal de télécommunication (4) avec au moins un expéditeur et au moins un destinataire pour la transmission de données, notamment d'un fichier qui est joint à un message, avec un processeur et une mémoire pour des données et des programmes, un moyen pour la reconnaissance (8) d'un fichier compressé (9) ou d'un fichier non compressé (2) et un moyen pour la compression (10) d'un fichier (2) reconnu comme étant non compressé étant prévus, **caractérisé par le fait que** le moyen pour la reconnaissance (8) d'un fichier compressé (9) ou d'un fichier non compressé (2) est conçu de telle sorte qu'un fichier est classé comme étant non compressé s'il est possible de diminuer de plus de 30 % la taille de ce fichier.

14. Terminal de télécommunication selon la revendication précédente 13, **caractérisé par le fait qu'**un moyen est prévu pour la décompression (11) du fichier joint (9) entré et reconnu comme étant compressé.

15. Terminal de télécommunication selon l'une des revendications précédentes 13 à 14, **caractérisé par le fait que** le moyen pour la compression (10) ou le moyen pour la décompression (11) est un programme de compression ou de décompression.

16. Terminal de télécommunication selon l'une des revendications précédentes 13 à 15, **caractérisé par le fait que** le moyen pour la reconnaissance (8) d'un fichier compressé ou d'un fichier non compressé est un programme ou un module de programme.

17. Terminal de télécommunication selon l'une des revendications précédentes 13 à 16, **caractérisé par le fait que** le système de radiocommunication (1) utilisé par le terminal de télécommunication (4) est un standard GSM.

18. Terminal de télécommunication selon l'une des revendications précédentes 13 à 17, **caractérisé par le fait que** le système de radiocommunication (1) utilisé par le terminal de télécommunication (4) est un standard DCS.

19. Terminal de télécommunication selon l'une des revendications précédentes 13 à 18, **caractérisé par le fait que** le système de radiocommunication (1) utilisé par le terminal de télécommunication (4) est un standard UMTS.

20. Terminal de télécommunication selon l'une des revendications précédentes 13 à 19, **caractérisé par le fait que** le système de radiocommunication (1) utilisé par le terminal de télécommunication (4) est un standard CTS.
